# EUROPÄISCHE PATENTANMELDUNG

(11) **EP 0 525 225 A1**
(43) Veröffentlichungstag der Anmeldung: **03.02.1993**
(21) Anmeldenummer: 91112450.1
(22) Anmeldetag: 24.07.1991
(51) Int. Cl.: H01L 31/048

(54) **Befestigung von rahmenlosen Solarmodulen**

(71) Anmelder: Siemens Solar GmbH, D-80807 München (DE)
(72) Erfinder: Riermeier, Manfred, W-8059 Oberneuching (DE)
(74) Vertreter: Fuchs, Franz-Josef, Dr.-Ing.

(57) **Zusammenfassung**

Für rahmenlose Solarmodule mit Glassubstraten wird vorgeschlagen, im nicht von Solarzellen bedeckten Randbereich der Substrate Bohrungen vorzusehen, mit deren Hilfe die Module miteinander und/oder mit einer Unterlage verbunden werden können.

## Beschreibung

Die Erfindung betrifft ein rahmenloses Solarmodul mit Glassubstrat.

Zur Erhöhung der mechanischen Festigkeit und zur einfacheren Handhabung sind Solarmodule üblicherweise mit einem Rahmen, beispielsweise aus einem Aluminiumprofil, eingefaßt. Da jedoch der Rahmen einen nicht unbeträchtlichen Anteil an den relativ hohen Gesamtkosten des Moduls ausmacht, sind für verschiedene Anwendungen rahmenlose Solarmodule bevorzugt. Insbesondere bei stationärer Aufstellung von Solarmodulen, vor allem für Solarenergieparks mit einer Vielzahl von Solarmodulen, kann ohne größere Nachteile auf den Rahmen verzichtet werden.

Während "normale" Module am bzw. über den Rahmen an einer Unterlage befestigt werden können, müssen für rahmenlose Solarmodule spezielle Klammern zur Halterung der Module vorgesehen werden. Eine weitere, allerdings irreversible Befestigung von Solarmodulen kann durch Kleben erfolgen.

Aufgabe der vorliegenden Erfindung ist es, eine einfache und variable Befestigung für Solarzellen anzugeben. In einer weiteren Aufgabenstellung soll es mit der Erfindung möglich sein, insbesondere mehrere Solarmodule nebeneinander in einfacher Weise zu befestigen.

Diese Aufgabe wird durch ein Solarmodul der eingangs genannten Art erfindungsgemäß dadurch gelöst, daß im Randbereich des Glassubstrats Bohrungen zur Befestigung des Solarmoduls vorgesehen sind.

Weitere Ausgestaltungen der Erfindung sind den Unteransprüchen zu entnehmen.

Für die Erfindung sind herkömmliche rahmenlose Module mit der Maßgabe geeignet, daß auf dem Glassubstrat ein zur Befestigung ausreichend breiter Randstreifen vorgesehen ist, welcher nicht von Solarzellen bedeckt ist. Zur Befestigung der erfindungsgemäßen Solarmodule können diese beispielsweise auf eine beliebige Unterlage durch die Bohrungen aufgeschraubt werden. Neben dem Verschrauben sind natürlich auch andere, diesen gleichwirkende Befestigungsmöglichkeiten denkbar, bei denen beliebige Befestigungselemente wie Nägel, Bolzen, Nieten und dergleichen durch die Bohrungen gesteckt und irgendwie fixiert werden. In allen Fällen wird mit der Erfindung gegenüber den bisher zur Befestigung verwendeten Klemmen eine vereinfachte, kostengünstige und für jegliche Unterlage geeignete Befestigungsmöglichkeit angegeben.

Zur sicheren Befestigung ist es ausreichend, wenn ein Modul an zwei einander gegenüberliegenden Seiten jeweils zumindest zwei Bohrungen besitzt. Üblicherweise werden dazu die Längsseiten ausgewählt. Je nach Größe des Moduls können jedoch noch weitere, auch an den Schmalseiten des Moduls gelegene Bohrungen vorgesehen sein.

Zur Verringerung der Bruchgefahr beim Verschrauben oder sonstigen Befestigen des Moduls ist in einer Ausgestaltung der Erfindung vorgesehen, in die Bohrungen Kunststoffbuchsen einzustecken. Dadurch wird bei großer mechanischer Beanspruchung des Moduls bzw. der Befestigung eine zu starke Reibung des Befestigungsmittels am Glassubstrat sowie Zug- und Druckspannungen vermieden. Über das weiche und/oder elastische Material der Kunststoffbuchse können so an der Befestigung des Moduls auftretende Kräfte abgepuffert werden, wodurch sich die Bruchgefahr des Moduls verringert.

Mehrere der erfindungsgemäßen Solarmodule können in vorteilhafter Weise derartig überlappend nebeneinander angeordnet werden, daß sich die Bohrungen benachbarter Solarmodule überlappen und so jeweils zwei Module miteinander verschraubt werden können. Dies verringert die Anzahl der für n Module erforderlichen Befestigungspunkte um den Faktor (n + 2)/2n. Bei einer regelmäßigen, derartig überlappenden Anordnung sind mehrere Solarmodule schindelartig in Form eines versetzten Stapels übereinander angeordnet. Dies hat bei einer von der Horizontalen abweichenden Aufstellung den Vorteil, daß die jeweilige Oberkante jedes einzelnen Moduls von der Unterkante des benachbarten Moduls abgedeckt ist und dadurch vor auftreffenden Regentropfen oder anderem Niederschlag geschützt ist. Da die nach oben weisende Kante eines im Freien aufgestellten rahmenlosen Solarmoduls die am meisten gefährdete Stelle bezüglich des Eindringens von Feuchtigkeit in das Modul ist, wird mit der schindelartigen Anordnung ein erhöhter Näßeschutz und somit eine höhere Beständigkeit gegenüber feuchtigkeitsbedinger Korrosion gewährleistet. Dadurch wird auch die Lebensdauer der rahmenlosen Solarmodule erhöht.

Besonders geeignet ist die schindelartige Anordnung mehrerer Solarmodule zur Bestückung von geneigten Gebäudedächern und -fassaden mit Solarmodulen. Die Solarmodule können auf diese Weise funktionelle Aufgaben als Fassadenverkleidung übernehmen.

Im folgenden wird die Erfindung anhand eines Ausführungsbeispiels und der dazugehörigen vier Figuren näher erläutert. Dabei zeigen
Figur 1 ein bekanntes rahmenloses Solarmodul im schematischen Querschnitt,
Figur 2 ein erfindungsgemäßes Solarmodul in der Draufsicht,
Figur 3 eine überlappende Verschraubung zweier erfindungsgemäßer Solarmodule im schematischen Querschnitt und
Figur 4 eine schindelartig Anordnung mehrerer Solarmodule.

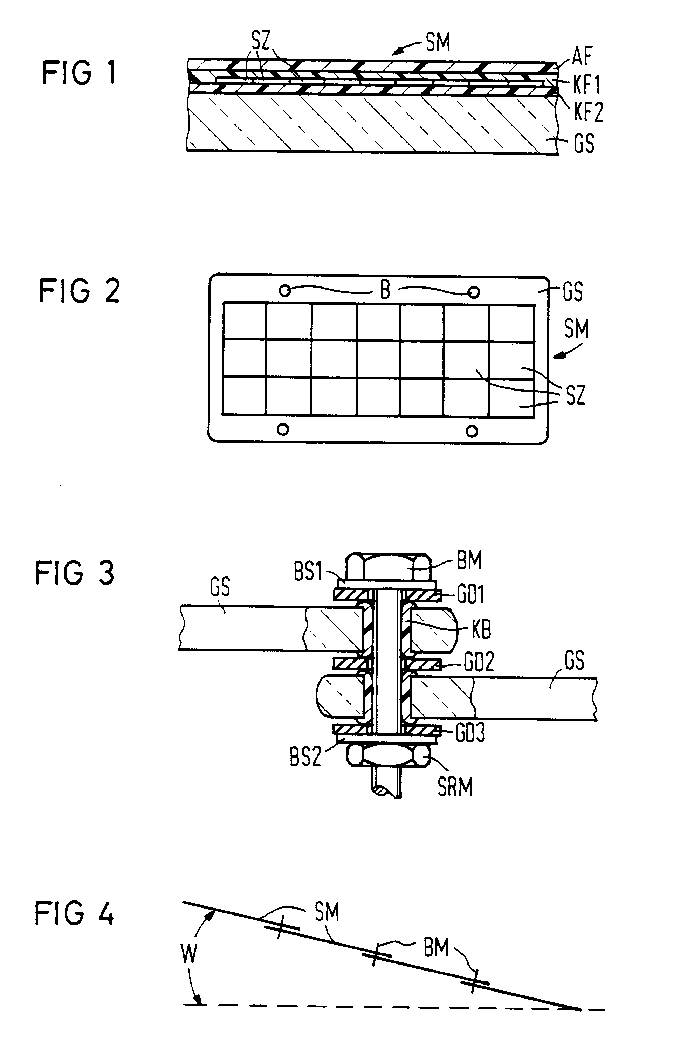

Figur 1: Ein rahmenloses Solarmodul SM wird üblicherweise auf einem Glassubstrat GS aufgebaut, welches zum Beispiel aus 4 mm dickem gehärteten Solarglas besteht. Auf das Glassubstrat GS wird nun ein Schichtaufbau auflaminiert, welcher aus einer ersten Kunststoffolie KF1, den elektrisch miteinander verschalteten Solarzellen SZ, einer zweiten Kunststoffolie KF2 und einer Verbundfolie als Abdeckfolie AF besteht. Das Laminieren erfolgt im Vakuum bei erhöhter Temperatur, wobei die Kunststoffolien miteinander verschweißt werden und mit dem Glassubstrat einen festen Verbund bilden. Ein derartiges Solarmodul SM kann mit einem Rahmen versehen oder ohne weitere konstruktive Änderung als rahmenloses Solarmodul verwendet werden.

Figur 2: Das erfindungsgemäße Solarmodul SM ist auf einem rechteckigen Glassubstrat GS aufgebaut. Jeweils zwei Bohrungen B befinden sich an den Längsseiten des Glassubstrats auf einem nicht von Solarzellen SZ bedeckten Randstreifen. In dem Ausführungsbeispiel besitzt das Glassubstrat eine Abmessung von 1000 x 500 mm, wobei der Randstreifen mit den Bohrungen B eine Breite von 50 mm, der Randstreifen der Schmalseiten dagegen nur ca. 20 mm bemißt. Der Abstand der Bohrungen auf der Längsseite beträgt 510 mm. Die angegebenen Maße sind jedoch nicht erfindungsgewesentlich weil beliebig variierbar und daher nicht als Einschränkung anzusehen.

Zur Herstellung des erfindungsgemäßen Solarmoduls ist es möglich, ein bereits vorgebohrtes Glassubstrat zu verwenden und auf diesem den Schichtaufbau zu laminieren, oder die Bohrungen erst nach dem Laminieren einzubringen. Im ersteren Fall werden die die Bohrungen B überlappenden Folien mit den Schrauben einfach durchstossen.

Eine vorzeitige Ablösung der Folienkanten am Rand des Solarmoduls SM wird vermieden, wenn die Folien nicht bündig mit dem Glassubstrat GS abschließen und die Stoßkante des Solarmoduls SM daher nur vom Glassubstrat GS gebildet wird. Die mechanische Einwirkung auf die Folienkante beim Transport und bei der Handhabung des Solarmoduls SM wird dadurch reduziert.

Figur 3 zeigt im schematischen Querschnitt die Verschraubung zweier am Randbereich überlappender Solarmodule SM. In die überlappenden Bohrungen sind Kunststoffbuchsen KB eingesteckt, die dem zum Beispiel als Schraube ausgebildeten Befestigungsmittel BM eine sichere Führung geben. An der Unterseite wird die Verschraubung durch eine Schraubenmutter SRM vervollständigt. Der durch die Verschraubung erzeugte Druck auf die Glassubstrat wird im Ausführungsbeispiel durch drei Gummidichtungen GD1, GD2 und GD3 aufgefangen, die jeweils zwischen dem Schraubenkopf des Befestigungsmittels BM und dem oberen Glassubstrat, zwischen beiden Glassubstraten und zwischen dem unteren Glassubstrat und der Schraubenmutter SRM angeordnet sind. Im Ausführungsbeispiel ist der Aufbau noch durch zwei Beilagscheiben BS1 und BS2 vervollständigt.

Bevorzugtes Material für das Befestigungsmittel BM und die Beilagscheiben BS ist nichtrostender Stahl.

Das Befestigungsmittel kann ausschließlich zur Verschraubung zweier Solarmodule SM miteinander oder zusätzlich noch zur Befestigung der miteinander verschraubten Solarmodule mit einer Unterlage (in der Figur nicht dargestellt) verwendet werden.

In Figur 4 ist ein aus vier Solarmodulen SM bestehender schindelartiger Solarmodulaufbau schematisch dargestellt. Werden die Solarmodule SM in einem Winkel W zur Horizontalen aufgestellt, ist die in der Figur dargestellte Überlappung mit den gegen Niederschlag geschützten Oberkanten der Solarmodule von besonderem Vorteil. Nicht dargestellt ist in der Figur die Unterlage, auf die Solarmodule befestigt sein können, welche zum Beispiel ein besonderes Gestell oder auch ein Gebäude einschließlich Dach sein kann.

## Patentansprüche

1. Rahmenloses Solarmodul mit einem Glassubstrat, dadurch gekennzeichnet, daß im Randbereich des Glassubstrats (GS) Bohrungen (B) zur Befestigung des Solarmoduls (SM) vorgesehen sind.

2. Solarmodul nach Anspruch 1, dadurch gekennzeichnet, daß an zwei einander gegenüberliegenden Seiten des Moduls (SM) jeweils zumindest zwei Bohrungen (B) vorgesehen sind.

3. Solarmodul nach Anspruch 1 oder 2, dadurch gekennzeichnet, daß in die Bohrungen im Glassubstrat eine Kunststoffbuchse (KB) eingesteckt ist.

4. Solarmodul nach einem der Ansprüche 1 bis 3, dadurch gekennzeichnet, daß es mit zumindest einem weiteren gleichartigen Solarmodul (SM) im Randbereich überlappend verschraubt ist.

5. Solarmodul nach Anspruch 4, dadurch gekennzeichnet, daß mehrere Solarmodule (SM) schindelartig in Form eines versetzten Stapels übereinander angeordnet sind, wobei jeweils nur die Randbereiche mit den Bohrungen (B) einander überlappen und wobei jeweils zwei übereinanderliegende Solarmodule an den Bohrungen miteinander verschraubt sind.

6. Solarmodul nach Anspruch 5, dadurch gekennzeichnet, daß die Module in dem schindelartigen Stapel zusätzlich mit einer Unterlage verschraubt sind.

7. Solarmodul nach Anspruch 5 oder 6, dadurch gekennzeichnet, daß der Stapel auf einem Hausdach befestigt ist.

8. Solarmodul nach Anspruch 5 oder 6, dadurch gekennzeichnet, daß der Stapel an einer Gebäudefassade befestigt ist.
